# FASCICULE DE BREVET EUROPEEN

(11) **EP 1 307 606 B1**
(45) Date de publication et mention de la délivrance du brevet: **08.03.2006**
(21) Numéro de dépôt: 01956620.7
(22) Date de dépôt: 20.07.2001
(51) Int. Cl.: C23C 16/26, C23C 16/02, C23C 16/04

(54) **REVETEMENT BARRIERE**
SPERRBESCHICHTUNG
BARRIER COATING

(30) Priorité: 01.08.2000 FR 0010100
(43) Date de publication de la demande: 07.05.2003
(73) Titulaire: SIDEL, 76053 Le Havre Cedex (FR)
(72) Inventeur: BELDI, Nasser SIDEL, F-76053 Le Havre Cedex (FR); ADRIANSENS, Eric SIDEL, F-76053 Le Havre Cedex (FR)
(74) Mandataire: Siloret, Patrick
(86) Numéro de dépôt international: PCT/FR2001/002367
(87) Numéro de publication internationale: WO 2002/010473

(56) Documents cités:
- WO-A-99/01589
- WO-A-99/49991
- DE-A- 3 047 888
- PATENT ABSTRACTS OF JAPAN vol. 1999, no. 14, 22 décembre 1999 (1999-12-22) & JP 11 245327 A (SONY CORP), 14 septembre 1999 (1999-09-14)
- LEE J H ET AL: "MECHANICAL PROPERTIES OF A-C:H AND A-C:H/SIOX NANOCOMPOSITE THIN FILMS PREPARED BY ION-ASSISTED PLASMA-ENHANCED CHEMICAL VAPOR DEPOSITION" THIN SOLID FILMS,CH,ELSEVIER-SEQUOIA S.A. LAUSANNE, vol. 280, no. 1/02, 1 juillet 1996 (1996-07-01), pages 204-210, XP000637289 ISSN: 0040-6090
- FINCH D S ET AL: "Diamond-like carbon, a barrier coating for polymers used in packaging applications" PACK TECHNOL SCI;PACKAGING TECHNOLOGY & SCIENCE MAR-APR 1996 JOHN WILEY & SONS LTD, CHICHESTER, ENGL, vol. 9, no. 2, mars 1996 (1996-03), pages 73-85, XP000997366
- DATABASE WPI Section Ch, Week 198519 Derwent Publications Ltd., London, GB; Class A18, AN 1985-112799 XP002164367 & JP 60 053545 A (KAO CORP), 27 mars 1985 (1985-03-27)
- PATENT ABSTRACTS OF JAPAN vol. 014, no. 058 (M-0930), 2 février 1990 (1990-02-02) & JP 01 283136 A (MITSUBISHI MONSANTO CHEM CO;OTHERS: 01), 14 novembre 1989 (1989-11-14)

## Description

L'invention concerne le domaine des revêtements barrières en couche mince déposés en mettant en oeuvre un plasma à faible pression. Pour obtenir de tels revêtements, un fluide réactionnel est injecté sous faible pression dans une zone de traitement. Ce fluide, lorsqu'il est porté aux pressions utilisées, est généralement gazeux. Dans la zone de traitement, un champ électromagnétique est instauré pour porter ce fluide à l'état de plasma c'est-à-dire pour en provoquer une ionisation au moins partielle. Les particules issues de ce mécanisme d'ionisation peuvent alors se déposer sur les parois de l'objet qui est placé dans la zone de traitement.

Les dépôts par plasmas à basse pression, aussi appelé plasmas froids, permettent de déposer des couches minces sur des objets en matière plastique sensible à la température tout en garantissant une bonne adhésion physico-chimique du revêtement déposé sur l'objet.

Une telle technologie de dépôt est utilisée dans diverses applications. L'une de ces applications concerne le dépôt de revêtements fonctionnels sur des films ou des récipients, notamment dans le but de diminuer leur perméabilité aux gaz tels que l'oxygène et le dioxyde de carbone.

Notamment, il est récemment apparu qu'une telle technologie pouvait être utilisée pour revêtir d'un matériau barrière les bouteilles en plastique destinées à conditionner des produits sensibles à l'oxygène, tels que la bière et les jus de fruits, ou des produits carbonatés tels que les sodas.

Le document WO99/49991 décrit un dispositif qui permet de recouvrir la face interne ou externe d'une bouteille en plastique avec en revêtement barrière. Dans ce document, il est envisagé l'utilisation d'un revêtement à base de carbone amorphe hydrogéné.

Il est par ailleurs connu d'utiliser des revêtements denses à base d'oxyde de silicium de type SiOx déposés par plasma basse pression pour diminuer la perméabilité de substrats plastiques. Cependant, lorsqu'ils sont déposés sur des substrats déformables, ces revêtements s'avèrent ne pas pouvoir résister aux déformations subies par le substrat. En effet, malgré la très forte adhésion au substrat, la déformation de ce dernier conduit à l'apparition de micro fissures dans le revêtement, ce qui en détériore les propriétés barrières.

Or, certaines applications nécessitent que le revêtement puisse résister malgré les déformations du substrat. Ainsi, une bouteille plastique remplie d'un liquide carbonaté tel qu'un soda ou tel que de la bière est soumise à une pression interne de plusieurs bars (1bar=100.000 Pa) qui peut conduire, dans le cas des bouteilles les plus légères, à un fluage de la matière plastique se traduisant par une légère augmentation du volume de la bouteille. Dans un tel cas, les matériaux denses tel que le SiOx, du fait de leur élasticité beaucoup plus faible que celle du substrat plastique, peuvent se détériorer au point de perdre un grande partie des propriétés barrières de la bouteille.

L'invention a donc pour but de proposer un nouveau type de revêtement optimisé pour obtenir des propriétés barrières de très haut niveau.

Dans ce but, l'invention propose tout d'abord un revêtement barrière aux gaz déposé sur un substrat polymère par plasma à basse pression, selon laquelle ledit revêtement comporte une couche barrière à base d'oxyde de silicium qui est recouverte d'une couche protectrice de carbone amorphe hydrogéné, et est caractérisé en ce que la couche barrière présente une épaisseur comprise entre 8 et 20 nanomètres et en ce que la couche protectrice présente une épaisseur inférieure à 20 nanomètres.

Selon d'autres caractéristiques de ce revêtement selon l'invention ;
- la couche barrière est composée essentiellement d'oxyde de silicium de formule SiOx, où x est compris entre 1.5 et 2.3 ;
- la couche protectrice présente une épaisseur inférieure à 10 nanomètres ;
- la couche barrière est obtenue par dépôt par plasma à basse pression d'un composé organosilicé en présence d'un excès d'oxygène ;
- la couche protectrice est obtenue par dépôt par plasma à basse pression d'un composé hydrocarboné ;
- entre le substrat et la couche barrière, il est déposé une couche d'interface ;
- la couche d'interface est obtenue par dépôt par plasma à basse pression d'un composé organosilicé en l'absence d'oxygène additionnel ; et
- la couche d'interface est obtenue par dépôt par plasma à basse pression d'un composé organosilicé en présence d'azote.

L'invention concerne aussi un procédé mettant en oeuvre un plasma à faible pression pour déposer un revêtement barrière sur un substrat à traiter, du type dans lequel le plasma est obtenu par ionisation partielle, sous l'action d'un champ électromagnétique, d'un fluide réactionnel injecté sous faible pression dans une zone de traitement, caractérisé en ce qu'il comporte au moins une étape consistant à déposer une couche barrière à base d'oxyde de silicium, et en ce qu'il comporte une étape ultérieure consistant à déposer sur la couche barrière une couche protectrice de carbone amorphe hydrogéné obtenue par plasma à basse pression.

Selon d'autres caractéristiques du procédé selon l'invention :
- la couche protectrice est obtenue par dépôt par plasma à basse pression d'un composé hydrocarboné ;
- le composé hydrocarboné est de l'acétyléne ;
- la couche barrière est obtenue par dépôt par plasma à basse pression d'un composé organosillcé en présence d'un excès d'oxygène ;
- le procédé comporte une étape préalable consistant à déposer une couche d'interface entre le substrat et la couche barrière ; et
- la couche d'interface est obtenue en portant à l'état de plasma un mélange comportant au moins un composé organosilicé et un composé azoté.

L'invention concerne aussi un récipient en matière polymère, caractérisé en ce qu'il est recouvert sur au moins une de ses faces d'un revêtement barrière du type décrit plus haut. Ce récipient est revêtu d'un revêtement barrière par exemple sur sa face interne et il peut s'agir d'une bouteille en polyéthylène téréphtalate.

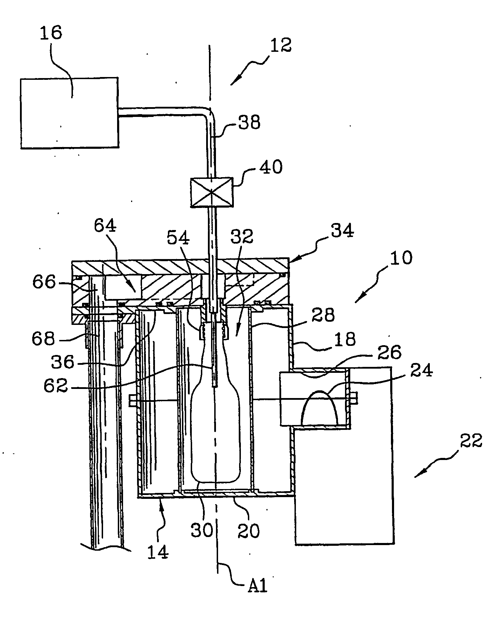

D'autres caractéristiques et avantages de l'invention apparaîtront à la lecture de la description détaillée qui suit pour la lecture de laquelle on se reportera à la figure unique annexée.

On a illustré sur la figure unique une vue schématique en coupe axiale d'un exemple de réalisation d'un poste de traitement 10 permettant la mise en oeuvre d'un procédé conforme aux enseignements de l'invention. L'invention sera ici décrite dans le cadre du traitement de récipients en matière plastique. Plus précisément, on décrira un procédé et un dispositif permettant de déposer un revêtement barrière sur la face interne d'une bouteille en matériau plastique.

Le poste 10 peut par exemple faire partie d'une machine rotative comportant un carrousel animé d'un mouvement continu de rotation autour d'un axe vertical.

Le poste de traitement 10 comporte une enceinte externe 14 qui est réalisée en matériau conducteur de l'électricité, par exemple en métal, et qui est formée d'une paroi cylindrique tubulaire 18 d'axe A1 vertical. L'enceinte 14 est fermée à son extrémité inférieure par une paroi inférieure de fond 20.

A l'extérieur de l'enceinte 14, fixé à celle-ci, on trouve un boîtier 22 qui comporte des moyens (non représentés) pour créer à l'intérieur de l'enceinte 14 un champ électromagnétique apte à générer un plasma. En l'occurrence, il peut s'agir de moyens aptes à générer un rayonnement électromagnétique dans le domaine UHF, c'est-à-dire dans le domaine des micro-ondes. Dans ce cas, le boîtier 22 peut donc renfermer un magnétron dont l'antenne 24 débouche dans un guide d'onde 26. Ce guide d'onde 26 est par exemple un tunnel de section rectangulaire qui s'étend selon un rayon par rapport à l'axe A1 et qui débouche directement à l'intérieur de l'enceinte 14, au travers de la paroi latérale 18. Toutefois, l'invention pourrait aussi être mise en oeuvre dans le cadre d'un dispositif muni d'une source de rayonnement de type radiofréquence, et/ou la source pourrait aussi être agencée différemment, par exemple à l'extrémité axiale inférieure de l'enceinte 14.

A l'intérieur de l'enceinte 14, on trouve un tube 28 d'axe A1 qui est réalisé avec un matériau transparent pour les ondes électromagnétiques introduites dans l'enceinte 14 via le guide d'onde 26. On peut par exemple réaliser le tube 28 en quartz. Ce tube 28 est destiné à recevoir un récipient 30 à traiter. Son diamètre interne doit donc être adapté au diamètre du récipient. Il doit de plus délimiter une cavité 32 dans laquelle il sera créé une dépression une fois le récipient à l'intérieur de l'enceinte.

Comme on peut le voir sur la figure, l'enceinte 14 est partiellement refermée à son extrémité supérieure par une paroi supérieure 36 qui est pourvue d'une ouverture centrale de diamètre sensiblement égal au diamètre du tube 28 de telle sorte que le tube 28 soit totalement ouvert vers le haut pour permettre l'introduction du récipient 30 dans la cavité 32. Au contraire, on voit que la paroi inférieure métallique 20, à laquelle l'extrémité inférieure du tube 28 est reliée de manière étanche, forme le fond de la cavité 32.

Pour refermer l'enceinte 14 et la cavité 32, le poste de traitement 10 comporte donc un couvercle 34 qui est mobile axialement entre une position haute (non représentée) et une position basse de fermeture illustrée sur la figure. En position haute, le couvercle est suffisamment dégagé pour permettre l'introduction du récipient 30 dans la cavité 32.

En position de fermeture, le couvercle 34 vient en appui de manière étanche contre la face supérieure de la paroi supérieure 36 de l'enceinte 14.

De manière particulièrement avantageuse, le couvercle 34 n'a pas comme seule fonction d'assurer la fermeture étanche de la cavité 32. Il porte en effet des organes complémentaires.

Tout d'abord, le couvercle 34 porte des moyens de support du récipient. Dans l'exemple illustré, les récipients à traiter sont des bouteilles en matériau thermoplastique, par exemple en polyéthylène téréphtalate (PET). Ces bouteilles comportent une collerette en excroissance radiale à la base de leur col de telle sorte qu'il est possible de les saisir à l'aide d'une cloche à griffes 54 qui vient s'engager ou s'encliqueter autour du col, de préférence sous la collerette. Une fois portée par la cloche à griffes 54, la bouteille 30 est plaquée vers le haut contre une surface d'appui de la cloche à griffes 54. De préférence, cet appui est étanche de telle sorte que, lorsque le couvercle est en position de fermeture, l'espace intérieur de la cavité 32 est séparé en deux parties par la paroi du récipient : l'intérieur et l'extérieur du récipient.

Cette disposition permet de ne traiter que l'une des deux surfaces (intérieure ou extérieure) de la paroi du récipient. Dans l'exemple illustré, on cherche à ne traiter que la surface interne de la paroi du récipient.

Ce traitement interne impose donc de pouvoir contrôler à la fois la pression et la composition des gaz présents à l'intérieur du récipient. Pour cela, l'intérieur du récipient doit pouvoir être mis en communication avec une source de dépression et avec un dispositif d'alimentation en fluide réactionnel 12. Ce dernier comporte donc une source de fluide réactionnel 16 relié par une tubulure 38 à un injecteur 62 qui est agencé selon l'axe A1 et qui est mobile par rapport au couvercle 34 entre une position haute escamotée (non représentée) et une position basse dans laquelle l'injecteur 62 est plongé à l'intérieur du récipient 30, au travers du couvercle 34. Une vanne commandée 40 est interposée dans la tubulure 38 entre la source de fluide 16 et l'injecteur 62. L'injecteur 62 peut être un tube à paroi poreuse qui permet d'optimiser la répartition de l'injection de fluide réactionnel dans la zone de traitement.

Pour que le gaz injecté par l'injecteur 62 puisse être ionisé et former un plasma sous l'effet du champ électromagnétique créé dans l'enceinte, il est nécessaire que la pression dans le récipient soit inférieure à la pression atmosphérique, par exemple de l'ordre de 10 Pa (10⁻⁴ bar). Pour mettre en communication l'intérieur du récipient avec une source de dépression (par exemple une pompe), le couvercle 34 comporte un canal interne 64 dont une terminaison principale débouche dans la face inférieure du couvercle, plus précisément au centre de la surface d'appul contre laquelle est plaqué le col de bouteille 30.

On remarque que dans le mode de réalisation proposé, la surface d'appui n'est pas formée directement sur la face inférieure du couvercle mais sur une surface annulaire inférieure de la cloche à griffes 54 qui est fixée sous le couvercle 34. Ainsi, lorsque l'extrémité supérieure du col du récipient est en appui contre la surface d'appui, l'ouverture du récipient 30, qui est délimitée par cette extrémité supérieure, entoure complètement l'orifice par lequel la terminaison principale débouche dans la face inférieure du couvercle 34.

Dans l'exemple illustré, le canal interne 64 du couvercle 24 comporte une extrémité de jonction 66 et le circuit de vide de la machine comporte une extrémité fixe 68 qui est disposée de telle sorte que les deux extrémités 66, 68 soient en regard l'une de l'autre lorsque le couvercle est en position de fermeture.

La machine illustrée est prévue pour traiter la surface interne de récipients qui sont en matière relativement déformable. De tels récipients ne pourraient pas supporter une surpression de l'ordre de 10⁶ Pa (1 bar) entre l'extérieur et l'intérieur de la bouteille. Ainsi, pour obtenir à l'intérieur de la bouteille une pression de l'ordre de 10 Pa (10⁻⁴ bar) sans déformer la bouteille, il faut que la partie de la cavité 32 à l'extérieur de la bouteille soit, elle aussi, au moins partiellement dépressurisée. Aussi, le canal interne 64 du couvercle 34 comporte, en plus de la terminaison principale, une terminaison auxiliaire (non représentée) qui débouche elle aussi au travers de la face inférieure du couvercle, mais radialement à l'extérieur de la surface annulaire d'appui sur laquelle est plaquée le col du récipient.

Ainsi, les mêmes moyens de pompage créent simultanément le vide à l'intérieur et à l'extérieur du récipient.

Pour limiter le volume de pompage, et pour éviter l'apparition d'un plasma inutile à l'extérieur de la bouteille, il est préférable que la pression à l'extérieur ne descende pas en dessous de 5.000 à 10.000 Pa (0,05 à 0,1 bar), contre une pression d'environ 10 Pa (10⁻⁴ bar) à l'intérieur. On constate de plus que les bouteilles, même à parois minces, peuvent supporter cette différence de pression sans subir de déformation notable. Pour cette raison, Il est prévu de munir le couvercle d'une soupape commandée (non représentée) pouvant obturer la terminaison auxiliaire.

Le fonctionnement du dispositif qui vient d'être décrit peut donc être le suivant.

Une fois le récipient chargé sur la cloche à griffes 54, le couvercle s'abaisse vers sa position de fermeture. Dans le même temps, l'injecteur s'abaisse au travers de la terminaison principale du canal 64, mais sans l'obturer.

Lorsque le couvercle en position de fermeture, il est possible d'aspirer l'air contenu dans la cavité 32, laquelle se trouve reliée au circuit de vide grâce au canal interne 64 du couvercle 34.

Dans un premier temps, la soupape est commandée pour être ouverte si bien que la pression chute dans la cavité 32 à la fois à l'extérieur et à l'intérieur du récipient. Lorsque le niveau de vide à l'extérieur du récipient a atteint un niveau suffisant, le système commande la fermeture de la soupape. Il est alors possible de continuer le pompage exclusivement à l'intérieur du récipient 30.

Une fois la pression de traitement atteinte, le traitement peut commencer selon le procédé de l'invention.

Dans une variante préférée de l'invention, le procédé de dépôt comporte une première étape consistant à déposer directement sur le substrat, en l'occurrence sur la surface Interne de la bouteille, une couche d'interface composée essentiellement de silicium, de carbone, d'oxygène, d'azote et d'hydrogène. La couche d'interface pourra bien entendu comporter d'autres éléments en quantités faibles ou à l'état de traces, ces autres composants provenant alors d'impuretés contenus dans les fluides réactionnels utilisés ou tout simplement d'impuretés dues à la présence d'air résiduel encore présent en fin de pompage.

Pour obtenir une telle couche d'interface, il faut injecter dans la zone de traitement un mélange comportant un composé organosilicé, c'est-à-dire comportant essentiellement du carbone, du silicium, de l'oxygène et de l'hydrogène, et un composé azoté.

Le composé organosilicé peut par exemple être un organosiloxane et, de manière simple, le composé azoté peut être de l'azote. On peut aussi envisager d'utiliser, en tant que composé organosilicé, un organosilazane qui contient au moins un atome d'azote.

Les organosiloxanes tels que l'hexamethyldisiloxane (HMDSO) ou le tetramethyldisiloxane (TMDSO) sont généralement liquides à température ambiante. Aussi, pour les injecter dans la zone de traitement, on peut soit utiliser un gaz porteur qui, dans un bulleur, se combine à des vapeurs de l'organosiloxane, ou tout simplement travailler à la pression de vapeur saturante de l'organosiloxane.

Si l'on utilise un gaz porteur, celui-ci pourra être un gaz rare tel que l'hélium ou l'argon. Toutefois, de manière avantageuse, on pourra tout simplement utiliser de l'azote gazeux (N2) en tant que gaz porteur.

Selon un mode de réalisation préféré, cette couche d'interface est obtenue en injectant dans la zone de traitement, en l'occurrence le volume interne d'une bouteille plastique de 500 ml, un débit de 4 sccm (standard centimètre cube par minute) de HMDSO en utilisant de l'azote gazeux comme gaz porteur sous un débit de 40 sccm. La puissance micro-ondes utilisée est par exemple de 400 W et le temps de traitement de l'ordre de 0.5 seconde. De la sorte, on obtient, dans un dispositif du type de celui décrit plus haut, une couche d'interface dont l'épaisseur est de l'ordre quelques nanomètres seulement.

Différentes analyses permettent de mettre en évidence que la couche d'interface ainsi déposée contient bien entendu du silicium mais qu'elle est particulièrement riche en carbone et en azote. Elle contient aussi de l'oxygène et de l'hydrogène. Les analyses montrent aussi qu'il existe de nombreuses liaisons chimique de type N-H.

Des essals ont montré qu'il était possible, au cours de cette étape de dépôt de la couche d'interface, de remplacer l'azote gazeux (N2) par de l'air (toujours sous un débit de 40 sccm dans l'exemple proposé) dont on salt qu'il est composé à près de 80% d'azote.

Sur cette couche d'interface, il est alors possible de déposer une couche barrière de matériau SIOx. II existe de nombreuses techniques pour déposer un tel matériau par plasma basse pression. A titre d'exemple, on peut se contenter de rajouter au mélange HMDSO / N2 décrit ci-dessus 80 sccm d'oxygène gazeux (O2). Cet ajout peut se faire de manière instantané ou de manière progressive.

L'oxygène, largement excédentaire dans le plasma provoque l'élimination presque complète des atomes de carbone, d'azote et hydrogène qui sont apportés soit par le HMDSO soit par l'azote utilisé comme gaz porteur. On obtient ainsi un matériau SiOx ou x, qui exprime le rapport de a quantité d'oxygène par rapport à la quantité de silicium, est généralement compris entre 1.5 et 2.3 suivant les conditions opératoires utilisées. Dans les conditions données plus haut, on peut obtenir une valeur de x supérieure à 2. Bien entendu, comme au cours de la première étape, des impuretés dues au mode d'obtention peuvent s'incorporer en faibles quantités dans cette couche sans en modifier de manière significative les propriétés.

La durée de la seconde étape de traitement peut varier par exemple de 2 à 4 secondes. L'épaisseur de la couche barrière ainsi obtenue est donc de l'ordre 6 à 20 nanomètres.

Les deux étapes du procédé dépôt peuvent être réalisées sous la forme de deux étapes parfaitement séparées ou, au contraire, sous la forme de deux étapes enchaînées, sans que le plasma ne s'éteigne entre les deux.

Conformément aux enseignements de l'invention, il est possible de recouvrir la couche barrière d'une couche protectrice de carbone amorphe hydrogéné déposé par plasma basse pression.

Du document WO99/49991 on sait que le carbone amorphe hydrogéné peut être utilisé en tant que couche barrière. Cependant, pour obtenir de bonnes valeurs de barrière, il est nécessaire de déposer une épaisseur de l'ordre de 80 à 200 nanomètres, épaisseur à partir de laquelle la couche de carbone présente une coloration dorée non négligeable.

Dans le cadre de la présente invention, la couche de carbone déposée présente une épaisseur qui est inférieure à 20 nanomètres. A ce niveau d'épaisseur, l'apport de cette couche supplémentaire en termes de barrière aux gaz n'est pas déterminant, même si cet apport existe.

Le principal intérêt de l'adjonction d'une couche de carbone amorphe hydrogéné d'aussi faible épaisseur réside dans le fait que l'on a constaté que la couche de SiOx ainsi protégée résiste mieux aux différentes déformations du substrat plastique.

A titre d'exemple, cette couche de carbone amorphe hydrogéné peut être produite en introduisant, dans la zone de traitement, de l'acétylène gazeux sous un débit d'environ 60 sccm pendant une durée de l'ordre de 0.2 seconde. La couche protectrice ainsi déposée est suffisamment mince pour que sa coloration soit à peine discernable à l'oeil nu, tout en accroissant de manière significative la résistance globale du revêtement.

Le revêtement barrière ainsi obtenu se révèle particulièrement performant. Ainsi, une bouteille standard en PET de 500 ml sur laquelle on a déposé un revêtement conformément aux enseignements de l'invention présente un taux de perméabilité correspondant à moins de 0.002 centimètre cube d'oxygène entrant dans la bouteille par jour, et elle conserve des propriétés barrières de niveau acceptable même si elle subit un fluage correspondant à un accroissement de volume supérieur à 5%.

## Revendications

1. Revêtement barrière aux gaz déposé sur un substrat polymère, ledit revêtement comportant une couche barrière à base d'oxyde de silicium qui est recouverte d'une couche protectrice de carbone amorphe hydrogéné, **caractérisé en ce que** la couche barrière présente une épaisseur comprise entre 8 et 20 nanomètres et **en ce que** la couche protectrice présente une épaisseur inférieure à 20 nanomètres.

2. Revêtement selon la revendication 1, **caractérisé en ce que** la couche barrière est composée essentiellement d'oxyde de silicium de formule SiOx, où x est compris entre 1.5 et 2.3.

3. Revêtement selon l'une quelconque des revendications précédentes, **caractérisé en ce que** la couche protectrice présente une épaisseur Inférieure à 10 nanomètres.

4. Revêtement selon l'une quelconque des revendications précédentes, **caractérisé en ce que** la couche barrière est obtenue par dépôt par plasma à basse pression d'un composé organosilicé en présence d'un excès d'oxygène.

5. Revêtement selon l'une quelconque des revendications précédentes, **caractérisé en ce que** la couche protectrice est obtenue par dépôt par plasma à basse pression d'un composé hydrocarboné.

6. Revêtement selon l'une quelconque des revendications précédentes, **caractérisé en ce que**, entre le substrat et la couche barrière, il est déposé une couche d'interface.

7. Revêtement selon la revendication 6, **caractérisé en ce que** la couche d'interface est obtenue par dépôt par plasma à basse pression d'un composé organosilicé en l'absence d'oxygène additionnel.

8. Revêtement selon la revendication 7, **caractérisé en ce que** la couche d'interface est obtenue par dépôt par plasma à basse pression d'un composé organosilicé en présence d'azote.

9. Récipient en matière polymère, **caractérisé en ce qu'**il est recouvert sur au moins une de ses faces d'un revêtement barrière conforme à l'une quelconque des revendications précédentes.

10. Récipient selon la revendication 9, **caractérisé en ce qu'**il est revêtu d'un revêtement barrière sur sa face interne.

11. Récipient selon l'une des revendications 9 ou 10, **caractérisé en ce qu'**il s'agit d'une bouteille en polyéthylène téréphtalate.

12. Procédé mettant en oeuvre un plasma à faible pression pour déposer un revêtement barrière sur un substrat polymère à traiter, du type dans lequel le plasma est obtenu par ionisation partielle, sous l'action d'un champ électromagnétique, d'un fluide réactionnel injecté sous faible pression dans une zone de traitement,
**caractérisé en ce qu'**ll comporte au moins une étape consistant à déposer une couche barrière à base d'oxyde de silicium présentant une épaisseur comprise entre 8 et 20 nanomàtres, et **en ce qu'**il comporte une étape ultérieure consistant à déposer par plasma à basse pression sur la couche barrière une couche protectrice, présentant une épaisseur inférieure à 20 nanomètres, de carbone amorphe hydrogéné.

13. Procédé selon la revendication 12, **caractérisé en ce que** la couche protectrice est obtenue par dépôt par plasma à basse pression d'un composé hydrocarboné.

14. Procédé selon la revendication 13, **caractérisé en ce que** le composé hydrocarboné est de l'acétylène.

15. Procédé selon l'une quelconque des revendications 12 à 14, **caractérisé en ce que** la couche barrière est obtenue par dépôt par plasma à basse pression d'un composé organosilicé en présence d'un excès d'oxygène.

16. Procédé selon l'une quelconque des revendications 12 à 15, **caractérisé en ce qu'**il comporte une étape préalable consistant à déposer une couche d'interface entre le substrat et la couche barrière.

17. Procédé selon la revendication 16, **caractérisé en ce que** la couche d'interface est obtenue en portant à l'état de plasma un mélange comportant au moins un composé organosilicé et un composé azoté.

## Patentansprüche

1. Gassperrüberzug, der auf ein Polymerträgermaterial aufgebracht wird, wobei der Überzug eine Sperrschicht auf der Basis von Siliciumoxid umfasst, die von einer Schutzschicht aus wasserstoffhaltigem amorphem Kohlenstoff bedeckt ist, **dadurch gekennzeichnet, dass** die Sperrschicht eine Dicke aufweist, die zwischen 8 und 20 Nanometern beträgt, und **dadurch**, dass die Schutzschicht eine Dicke von weniger als 20 Nanometern aufweist.

2. Überzug nach Anspruch 1, **dadurch gekennzeichnet, dass** die Sperrschicht im Wesentlichen aus Siliciumoxid mit der Formel SiOx besteht, wobei x zwischen 1,5 und 2,3 beträgt.

3. Überzug nach einem der vorhergehenden Ansprüche, **dadurch gekennzeichnet, dass** die Schutzschicht eine Dicke von weniger als 10 Nanometern aufweist.

4. Überzug nach einem der vorhergehenden Ansprüche, **dadurch gekennzeichnet, dass** die Sperrschicht durch Auftragen einer Organosiliciumverbindung mittels Niederdruck-Plasmaspritzen in Gegenwart eines Überschusses an Sauerstoff hergestellt wird.

5. Überzug nach einem der vorhergehenden Ansprüche, **dadurch gekennzeichnet, dass** die Schutzschicht durch Auftragen einer Kohlenwasserstoffverbindung mittels Niederdruck-Plasmaspritzen hergestellt wird.

6. Überzug nach einem der vorhergehenden Ansprüche, **dadurch gekennzeichnet, dass** zwischen dem Trägermaterial und der Sperrschicht eine Grenzflächenschicht aufgebracht ist.

7. Überzug nach Anspruch 6, **dadurch gekennzeichnet, dass** die Grenzflächenschicht durch Auftragen einer Organosiliciumverbindung mittels Niederdruck-Plasmaspritzen in Abwesenheit von zusätzlichem Sauerstoff hergestellt wird.

8. Überzug nach Anspruch 7, **dadurch gekennzeichnet, dass** die Grenzflächenschicht durch Auftragen einer Organosiliciumverbindung mittels Niederdruck-Plasmaspritzen in Gegenwart von Stickstoff hergestellt wird.

9. Behälter aus Polymermaterial, **dadurch gekennzeichnet, dass** er auf mindestens einer seiner Seiten mit einem Sperrüberzug nach einem der vorhergehenden Ansprüche bedeckt ist.

10. Behälter nach Anspruch 9, **dadurch gekennzeichnet, dass** er auf seiner Innenseite mit einem Sperrüberzug überzogen ist.

11. Behälter nach einem der Ansprüche 9 oder 10, **dadurch gekennzeichnet, dass** es sich um eine Flasche aus Polyethylenterephthalat handelt.

12. Verfahren, bei dem ein Niederdruckplasma angewendet wird, um einen Sperrüberzug auf ein zu bearbeitendes Polymerträgermaterial aufzubringen, von der Art, bei der das Plasma durch Teilionisation eines unter niedrigem Druck in einen Bearbeitungsbereich eingespritzten Reaktionsfluids unter der Wirkung eines elektromagnetischen Feldes hergestellt wird, **dadurch gekennzeichnet, dass** es mindestens einen Schritt umfasst, der darin besteht, eine Sperrschicht auf der Basis von Siliciumoxid aufzubringen, die eine Dicke aufweist, die zwischen 8 und 20 Nanometern beträgt, und **dadurch**, dass es einen späteren Schritt umfasst, der darin besteht, auf die Sperrschicht mittels Niederdruck-Plasmaspritzen eine Schutzschicht aus wasserstoffhaltigem amorphem Kohlenstoff aufzubringen, die eine Dicke von weniger als 20 Nanometern aufweist.

13. Verfahren nach Anspruch 12, **dadurch gekennzeichnet, dass** die Schutzschicht durch Auftragen einer Kohlenwasserstoffverbindung mittels Niederdruck-Plasmaspritzen hergestellt wird.

14. Verfahren nach Anspruch 13, **dadurch gekennzeichnet, dass** die Kohlenwasserstoffverbindung Acetylen ist.

15. Verfahren nach einem der Ansprüche 12 bis 14, **dadurch gekennzeichnet, dass** die Sperrschicht durch Auftragen einer Organosiliciumverbindung mittels Niederdruck-Plasmaspritzen in Gegenwart eines Überschusses an Sauerstoff hergestellt wird.

16. Verfahren nach einem der Ansprüche 12 bis 15, **dadurch gekennzeichnet, dass** es einen vorangehenden Schritt umfasst, der darin besteht, zwischen dem Trägermaterial und der Sperrschicht eine Grenzflächenschicht aufzubringen.

17. Verfahren nach Anspruch 16, **dadurch gekennzeichnet, dass** die Grenzflächenschicht hergestellt wird, indem ein Gemisch, das mindestens eine Organosiliciumverbindung und eine Stickstoffverbindung umfasst, in den Plasmazustand gebracht wird.

## Claims

1. Gas-barrier coating deposited on a polymer substrate, the said coating comprising a barrier layer based on silicon oxide which is covered with a protective layer of hydrogenated amorphous carbon, **characterized in that** the barrier layer has a thickness of between 8 and 20 nanometres and **in that** the protective layer has a thickness of less than 20 nanometres.

2. Coating according to Claim 1, **characterized in that** the barrier layer is essentially composed of silicon oxide of formula SiOx, where x is between 1.5 and 2.3.

3. Coating according to either of the preceding claims, **characterized in that** the protective layer has a thickness of less than 10 nanometres.

4. Coating according to any one of the preceding claims, **characterized in that** the barrier layer is obtained by low-pressure plasma deposition of an organosilicon compound in the presence of an excess of oxygen.

5. Coating according to any one of the preceding claims, **characterized in that** the protective layer is obtained by low-pressure plasma deposition of a hydrocarbon compound.

6. Coating according to any one of the preceding claims, **characterized in that** an interface layer is deposited between the substrate and the barrier layer.

7. Coating according to Claim 6, **characterized in that** the interface layer is obtained by low-pressure plasma deposition of an organosilicon compound in the absence of additional oxygen.

8. Coating according to Claim 7, **characterized in that** the interface layer is obtained by low-pressure plasma deposition of an organosilicon compound in the presence of nitrogen.

9. Container made of a polymer material, **characterized in that** it is covered on at least one of its faces with a barrier coating according to any one of the preceding claims.

10. Container according to Claim 9, **characterized in that** it is coated on its internal face with a barrier coating.

11. Container according to either of Claims 9 and 10, **characterized in that** it is a bottle made of polyethylene terephthalate.

12. Process using a low-pressure plasma for depositing a barrier coating on a polymer substrate to be treated, of the type in which the plasma is obtained by partial ionization, through the action of an electromagnetic field, of a reactive fluid injected at low pressure into a treatment zone, **characterized in that** it includes at least one step consisting in depositing a barrier layer based on silicon oxide having a thickness of between 8 and 20 nanometres and **in that** it includes a subsequent step consisting in depositing on the barrier layer, by low-pressure plasma deposition, a protective layer of hydrogenated amorphous carbon having a thickness of less than 20 nanometres.

13. Process according to Claim 12, **characterized in that** the protective layer is obtained by low-pressure plasma deposition of a hydrocarbon compound.

14. Process according to Claim 13, **characterized in that** the hydrocarbon compound is acetylene.

15. Process according to any one of Claims 12 to 14, **characterized in that** the barrier layer is obtained by low-pressure plasma deposition of an organosilicon compound in the presence of an excess of oxygen.

16. Process according to any one of Claims 12 to 15, **characterized in that** it includes a prior step consisting in depositing an interface layer between the substrate and the barrier layer.

17. Process according to Claim 16, **characterized in that** the interface layer is obtained by taking a mixture comprising at least one organosilicon compound and a nitrogen compound into the plasma state.
